# EUROPÄISCHE PATENTSCHRIFT

(11) **EP 4 005 195 B1**
(45) Veröffentlichungstag und Bekanntmachung des Hinweises auf die Patenterteilung: **10.09.2025**
(21) Anmeldenummer: 20789902.2
(22) Anmeldetag: 05.10.2020
(51) Int. Cl.: H04N 17/00, H04N 23/54, H10F 39/00

(54) **SENSORANORDNUNG**
SENSOR ARRANGEMENT
ENSEMBLE CAPTEUR

(30) Priorität: 07.10.2019 AT 508462019
(43) Veröffentlichungstag der Anmeldung: 01.06.2022
(73) Patentinhaber: Vexcel Imaging GmbH, 8010 Graz (AT)
(72) Erfinder: PONTICELLI, Martin, 8041 Graz (AT); GRUBER, Michael, 8044 Graz (AT); COSIC, Zanin, 8020 Graz (AT)
(74) Vertreter: Patentanwälte Pinter & Weiss OG
(86) Internationale Anmeldenummer: PCT/EP2020/077862
(87) Internationale Veröffentlichungsnummer: WO 2021/069382

(56) Entgegenhaltungen:
- EP-A2- 1 475 960
- DE-A1- 102014 212 104
- JP-A- 2010 118 892
- MEYER ARNE F ET AL: "A Head-Mounted Camera System Integrates Detailed Behavioral Monitoring with Multichannel Electrophysiology in Freely Moving Mice", NEURON, CELL PRESS, US, vol. 100, no. 1, 10 October 2018 (2018-10-10), pages 46, XP085502908, ISSN: 0896-6273, DOI: 10.1016/J.NEURON.2018.09.020

## Beschreibung

Die Erfindung betrifft ein Verfahren zur Herstellung einer Sensoranordnung, sowie eine Sensoranordnung mit zumindest einem elektrooptischen Sensor, der an einer Aufnahmestruktur einer Sensorhalterung befestigt ist, wobei der elektrooptische Sensor ein Sensorgehäuse mit einer daran angeordneten optisch aktiven Sensorschicht aufweist, wobei die optische aktive Sensorschicht eine lichtempfindliche Ebene ausbildet und wobei die Aufnahmestruktur unverstellbar ist.

Elektrooptische Sensorprodukte werden von der Industrie für unterschiedliche Anwendungen, insbesondere im Bereich der digitalen Photographie und der bildgebenden Messtechnik, entwickelt und weltweit angeboten. Für die Nutzung in einem photographischen Aufnahmegerät - also einer digitalen Kamera - ist die stabile und geometrisch exakte Verbindung zwischen Objektiv und elektrooptischen Sensor unumgänglich. Die optische Scharfabbildung gelingt nur, wenn die lichtempfindliche Ebene der optisch aktiven Sensorschicht in die Bildebene des Kameraobjektives eingebracht wird. Die Lagegenauigkeit dieser Positionierung ist anspruchsvoll und bedarf für hochwertige Geräte einer geometrischen Genauigkeit von im Allgemeinen zumindest unter 100 µm, für Spezialanwendungen, wie etwa die digitale Großformatfotographie, insbesondere im Bereich des Mobile Mapping, der Photogrammetrie, der Geomatik oder ähnlichen Anwendungen werden noch höhere Genauigkeiten gefordert, wobei als maximal zulässige Lagetoleranzen nur wenige Mikrometer, beispielsweise unter 10 µm oder sogar unter 3 µm gewünscht und/oder erforderlich sein können (jeweils in Lage, Höhe und Verkippung).

Elektrooptische Sensoren umfassen üblicherweise ein Sensorgehäuse aus einem Keramikmaterial, auf dem die optische aktive Sensorschicht angeordnet ist, die die lichtempfindliche Ebene ausbildet. Der elektrooptische Sensor weist weiters elektrische Kontakte auf, üblicherweise vergoldete Pins, die beispielsweise auf der der aktiven Sensorschicht gegenüberliegenden Seite über Lötstellen mit der Steuerelektronik des entsprechenden Mess- bzw. Kamerasystems verbunden werden können.

Nun ist die Lage des elektrooptischen Sensors - genauer der lichtempfindlichen Ebene desselben - in Bezug auf das Sensorgehäuse anfänglich nur unzulänglich genau bekannt. Die von den Herstellern angegebenen Spezifikationen haben oftmals weitaus größere Toleranzen, als sie für die qualitativ hochwertige Positionierung im Kamerakörper erforderlich sind. Bei handelsüblichen Produkten von CMOS- oder CCD-Sensoren können beispielsweise Toleranzen von etwa 300 µm in der Lage und 150 µm in der Höhe und für die Verkippung von den meisten Herstellern üblicherweise garantiert werden. Auch von hochwertigen Produkten werden Toleranzabweichungen in der Größenordnung von 10 µm oder weniger, wie sie für spezielle Anwendungen erforderlich sind, nicht erreicht.

Dies liegt einerseits daran, dass die geometrische Form des keramischen Sensorgehäuses nur unzureichend präzise bekannt ist und auch die Fertigungstoleranzen relativ groß sind, andererseits sind die Pixelelemente der optisch aktiven Sensorschicht üblicherweise mittels Klebeverbindungen an dem Sensorgehäuse befestigt, was zu zusätzlichen Toleranzabweichungen führen kann.

Für die Herstellung besonders genauer Mess- bzw. Kamerasysteme ist es also erforderlich, die Lage der lichtempfindlichen Ebene des elektrooptischen Sensors in seinem mechanischen Gehäuse in allen drei Koordinatenrichtungen zu bestimmen. Dazu wird üblicherweise der elektrooptische Sensor in einer justierbaren Aufnahmestruktur einer Sensorhalterung angeordnet, die eine gegenüber dem Objektiv definierte Position aufweist. Die Justierung der lichtempfindlichen Ebene erfolgt dann üblicherweise mittels Justierschrauben, nachdem der elektrooptische Sensor in dem Messsystem bzw. der Kamera eingebaut wurde. Zur Erleichterung der Justierung werden vom Hersteller üblicherweise Passpositionen angegeben, die eine Lagedefinition des Sensorgehäuses erlauben. Der Sensorhersteller beschreibt dazu Passlagen am Keramikgehäuse, die nun als Basis für die Lagebeschreibung des Sensors im Keramikgehäuse verwendet werden können (z.B. drei Positionen an der Kante des Keramikgehäuses für die Lage in X und Y sowie drei Positionen an der Unterseite des Keramikgehäuses für die vertikale Ausrichtung incl. Verkippung).

Der Justiervorgang muss üblicherweise händisch durchgeführt werden, wobei die Überprüfung der korrekten Position beispielsweise mithilfe von Testaufnahmen ermittelt wird. Für die Justierung kann beispielsweise mit dem zu justierenden Sensor an einem Justagetisch ein Bild einer Testvorlage erzeugt und mit einem Soll-Bild verglichen werden. Die mechanische Justage erfolgt dann mittels Stellschrauben oder ähnlicher mechanischer Aktuatoren und einer Micro- Bewegung des Sensors in seinem Rahmen, die über die Passpositionen überwacht werden kann. Eine softwareunterstützte Auswertung der Testbilder sowie eine computergestützte Bewegung oder Positionierung des Sensors können diesen iterativen, aufwändigen und anspruchsvollen Vorgang bis zu einem gewissen Grad unterstützen, dennoch ist für die Justierung technisch höchst qualifiziertes Personal erforderlich. Das Problem verstärkt sich, wenn auf einer einzigen Sensorhalterung (mit mehreren Aufnahmestrukturen für jeweils einen elektrooptischen Sensor) mehrere elektrooptische Sensoren aufeinander ausgerichtet und in die entsprechende Solllage gebracht werden sollen.

DE 10 2014 212104 A1 offenbart eine Vorrichtung und ein Verfahren zur relativen Positionierung einer Multiaperturoptik mit mehreren optischen Kanälen relativ zu einem Bildsensor.

EP 1 475 960 A2 offenbart ein Kameramodul mit einem Linsenhalter, an dem eine optische Linse angeordnet ist. An einer Unterseite des Linsenhalters ist eine Befestigungsfläche vorgesehen, an der ein Sensorhalter befestigt ist. Der Sensorhalter weist eine der Linse zugewandte Fläche auf, an der ein lichtempfindlicher Sensor angeordnet ist.

JP 2010 118892 A offenbart eine Bildlesevorrichtung, bei der verhindert wird, dass die Position eines Bildsensors durch eine Temperaturänderung verändert wird.

Die Veröffentlichung MEYER ARNE F et al.: "A Head-Mounted Camera System Integrates Detailed Behavioral Monitoring with Multichannel Electrophysiology in Freely Moving Mice", NEURON, CELL PRESS US, BD.100, Nr.1, 10.10.2018 offenbart eine Miniaturkamera für Mäuse, die die Merkmale des Oberbegriffs von Anspruch 8 aufweist.

Es ist ein Ziel der gegenständlichen Erfindung, eine Sensoranordnung und ein Verfahren zur Herstellung einer Sensoranordnung bereitzustellen, welche einerseits den Arbeitsaufwand für die Justierung von elektrooptischen Sensoren verringern oder vermeiden und mit denen andererseits höhere Genauigkeiten (d.h. geringere Toleranzen) erzielbar sind, um herstellungsbedingte Lagetoleranzen des Sensors möglichst kompensieren zu können.

Diese und weitere Ziele werden in einer Ausführungsform durch ein Verfahren der eingangs genannten Art gelöst, welches die folgenden Schritte aufweist: Bereitstellen eines elektrooptischen Sensors mit einem Sensorgehäuse und einer daran angeordneten optisch aktiven Sensorschicht, welche eine lichtempfindliche Ebene ausbildet, lagedefiniertes Anordnen des elektrooptischen Sensors in einer Messausnehmung einer Messhalterung, Ermitteln, mit einer Messeinheit, einer auf die Messhalterung bezogenen Lagetransformation der Ist-Lage der lichtempfindlichen Ebene gegenüber einer in Bezug auf die Messhalterung definierten Solllage der lichtempfindlichen Ebene, Herstellen einer Sensorhalterung mit einer unverstellbaren Aufnahmestruktur, welche die durch die Lagetransformation beschriebene Formabweichung des elektrooptischen Sensors von einer Sollform ausgleicht, Befestigen des elektrooptischen Sensors in der Aufnahmestruktur der Sensorhalterung. Das Verfahren erlaubt es, bereits anhand des elektrooptischen Sensors vor dem Einbau in eine Sensoranordnung und vor der elektrischen Inbetriebnahme des zu justierenden Sensors exakte Informationen über die erforderlichen Justierungshandlungen zu erhalten und diese Informationen bei der Herstellung der Sensorhalterung zu berücksichtigen. Die Messhalterung und die Sensorhalterung können dabei beispielsweise baugleich ausgeführt sein. Eine nachträgliche Justage nach dem Einbau der Sensoranordnung in die Kamera ist dadurch nicht mehr erforderlich.

Als "lagedefiniertes Anordnen" wird im Zusammenhang mit der gegenständlichen Offenbarung ein Anordnen bezeichnet, bei dem die Lage zumindest eines Positionierungsmerkmals des elektrooptischen Sensors in Bezug auf die Messhalterung eindeutig definiert ist. Das Positionierungsmerkmal kann beispielsweise eine Eckkante des Sensorgehäuses sein, die an einem bestimmten Punkt und in einer bestimmten Ausrichtung an der Messhalterung angeordnet ist. In vorteilhafter Weise kann das Positionierungsmerkmal der Positionierung des Sensors in der Aufnahmestruktur der Sensorhalterung entsprechen, beispielsweise indem die Messausnehmung der Messhalterung im Wesentlichen der Aufnahmestruktur der Sensorhalterung entspricht. Als Positionierungsmerkmale können beispielsweise die vom Hersteller des elektrooptischen Sensors bereitgestellten Passlagen und/oder andere Merkmale des elektrooptischen Sensors genutzt werden.

Als "Lagetransformation" wird im Zusammenhang mit der gegenständlichen Offenbarung ein definierter Rechenvorgang bezeichnet, mithilfe dessen Merkmale der Ist-Lage (z.B. Punkte, Flächen und/oder Formen) in die entsprechenden Merkmale der Sollage übergeführt werden können oder umgekehrt. Die Lagetransformation kann beispielsweise in Form einer Transformationsmatrix beschrieben werden.

In vorteilhafter Weise kann das Verfahren weiters die folgenden Schritte aufweisen: Messen, mit der Messeinheit, einer Abweichung zumindest eines Messpunkts der lichtempfindlichen Ebene und/oder des Sensorgehäuses von einer in Bezug auf die Messhalterung definierten Solllage dieses Messpunkts, Ermitteln der Ist-Lage der lichtempfindlichen Ebene aus zumindest einer gemessenen Abweichung, Ermitteln der Lagetransformation zwischen der gemessenen Position der lichtempfindlichen Ebene und der Solllage dieser lichtempfindlichen Ebene. Bereits die Messung eines einzelnen Messpunkts kann die Ermittlung einer (wenn auch unvollständigen) Lagetransformation ermöglichen, beispielsweise könnte lediglich die Position eines bekannten Merkmals auf der lichtempfindlichen Ebene gemessen und deren Abweichung von der Sollposition bestimmt werden. Die Lagetransformation kann dann beispielsweise einer Verschiebung der lichtempfindlichen Ebene gemäß der gemessenen Abweichung entsprechen. In vorteilhafter Weise werden jedoch weitere Messpunkte ermittelt, um mehrere Aspekte der Lagetransformation (insbesondere Translationen, Rotationen und gegebenenfalls Skalierungen in allen Achsenrichtungen) abbilden zu können.

Das Messen kann mithilfe beliebiger, zu diesem Zweck geeigneter direkter oder indirekter, vorzugsweise kontaktloser Messvorrichtungen erfolgen. Zu Beispielen geeigneter Messvorrichtungen zählen mechanische Messvorrichtungen, die eine Form mittels eines taktilen Abtastens ermitteln, wie etwa Mikrometer oder Messlehren, optische Messsysteme, die Bild-, Zeilen und/oder Pixelsensoren aufweisen, wie etwa 1D-, 2D, und 3D-Laser-Wegmesssensoren, Messvorrichtungen mit bildgebenden Sensoren, wobei die Ermittlung durch eine Bildauswertung erfolgt, und Messvorrichtungen, die die obigen Messverfahren kombiniert anwenden. Ein bevorzugtes Beispiel einer Messvorrichtung sind opto-mechanische Messvorrichtungen, bei denen die Positionierung des elektrooptischen Sensors mechanischer erfolgt und die Messung optisch durchgeführt wird. Die opto-mechanische Vermessung des Sensors in einem stabilen Rahmen mit definierten Passlagen kann beispielsweise über bekannte industrielle optische 3d-Messsysteme erfolgen. Ein Beispiel einer verwendbaren Messvorrichtung ist das unter der Bezeichnung "Vertex 251 UC" von der amerikanischen Firma Micro Vu, Windsor, CA, hergestellte Gerät.

In einer weiteren vorteilhaften Ausführungsform kann das Verfahren weiters die folgenden Schritte aufweisen: Anordnen zumindest einer Messkamera der Messeinheit in zumindest einer auf die Messhalterung bezogenen Raumposition, Erstellen zumindest einer Messaufnahme mit der zumindest einen Messkamera, wobei die Messaufnahme zumindest einen Teil der lichtempfindlichen Ebene und/oder des Sensorgehäuses und gegebenenfalls der Messhalterung umfasst, Ermitteln von Koordinaten des zumindest einen Messpunkts und gegebenenfalls von Koordinaten der Solllage dieses Messpunkts aus der zumindest einen Messaufnahme, Ermitteln der Lagetransformation zwischen der gemessenen Position der lichtempfindlichen Ebene und der Solllage dieser lichtempfindlichen Ebene aus den Koordinaten. Eine solche optische Messung und eine Auswertung der Messaufnahme ist verhältnismäßig einfach zu realisieren, erlaubt sehr genaue Ergebnisse und kann auch für große Chargen automatisiert durchgeführt werden.

In vorteilhafter Weise kann zumindest eine auf die Messhalterung bezogene Raumposition auf Basis der entsprechenden Messaufnahme ermittelt werden. Der Aufwand für die Positionierung von Messhalterung und Messeinheit kann dadurch verringert werden. Für die Ermittlung der Raumposition kann beispielsweise die Messhalterung entsprechende Markierungen aufweisen, anhand derer für jede einzelne Messaufnahme die jeweilige Relativposition zwischen Messhalterung und Raumposition der Messeinheit ermittelt werden kann, und/oder die Ermittlung kann anhand bekannter (Struktur-) Merkmale der Messhalterung erfolgen.

In vorteilhafter Weise kann die Sensorhalterung mit der Aufnahmestruktur unter Verwendung eines 3D-Druckverfahrens hergestellt werden. Hochpräzise 3D-Druckverfahren erlauben die Herstellung von Sensorhalterungen mit geringen Toleranzen, wobei die Aufnahmestruktur gegebenenfalls zur Erhöhung der Maßgenauigkeit nachbearbeitet werden kann, falls dies erforderlich ist.

Gemäß einer weiteren vorteilhaften Ausführungsform kann die Sensorhalterung mit der Aufnahmestruktur unter Verwendung eines spanabhebenden Verfahrens hergestellt werden.

Mittels hochpräziser spanabhebender Verfahren können Fertigungstoleranzen im Bereich von nur 5 µm erzielt werden. Als Material der Sensorhalterung können beispielsweise Metalllegierungen verwendet werden, die sich mechanisch ähnlich verhalten, wie das Material des Sensorgehäuses.

In einer vorteilhaften Ausführungsform können mehrere elektrooptische Sensoren in mehreren Aufnahmestrukturen einer einzigen Sensorhalterung befestigt werden. Dadurch lassen sich Großformatkameras herstellen, bei denen mehrere elektrooptische Sensoren zu einem großflächigen "Mosaik" zusammengefasst sind. Zu Beispielen solcher Kameras zählen etwa die in EP 1 384 046 B1 offenbarten Kamerasysteme.

In einem weiteren Aspekt betrifft die gegenständliche Offenbarung eine Sensoranordnung der eingangs genannten Art, wobei die Aufnahmestruktur dazu ausgebildet ist, eine zuvor ermittelte Formabweichung des elektrooptischen Sensors von einer Sollform auszugleichen. Eine solche Sensoranordnung lässt sich nicht nur kostengünstig herstellen, da auf Justiermittel, wie etwa Justierschrauben verzichtet werden kann, sondern sie lässt sich auch kostengünstig in ein Kamera- bzw. Messsystem einbauen, da eine aufwändige Justierung nicht erforderlich ist. Dennoch lassen sich Toleranzen erzielen, die bislang nur mit einer aufwändigen Justierung möglich waren. Dies unterstützt die Kalibrierung und erlaubt bessere Näherungswerte und eine optimal zentrierte Bildlage. Bei Kameraköpfen mit mehreren Sensoren wird die Bildschärfe im gesamten Bildbereich über alle Sensoren erheblich verbessert. Auch wird eine Verkippung des Sensors verhindert und damit wieder die Scharfstellung über das gesamte Bild verbessert.

Als "unverstellbare Aufnahmestruktur" wird im Zusammenhang mit der gegenständlichen Offenbarung eine Aufnahmestruktur bezeichnet, die eine Anordnung des elektrooptischen Sensors in einer definierten Position erlaubt. Eine Verstellung der Lage des elektrooptischen Sensors in der Aufnahmestruktur ist nicht erforderlich und nicht vorgesehen.

Als "Sollform" des elektrooptischen Sensors wird im Zusammenhang mit der gegenständlichen Offenbarung eine theoretische Form bezeichnet, die sich anhand der Maßangaben ohne Toleranzabweichungen einstellen müsste.

Als "Formabweichung von einer Sollform" wird im Zusammenhang mit der gegenständlichen Offenbarung die Summe aller ermittelten Abweichungen von Ist-Lagen zu Solllagen bezeichnet. Die Formabweichung kann insbesondere durch die zuvor beschriebene Lagetransformation definiert beziehungsweise beschrieben sein.

In vorteilhafter Weise kann der elektrooptische Sensor formschlüssig in der Aufnahmestruktur aufgenommen sein, was eine besonders einfache Montage erlaubt. Durch eine solche formschlüssige Aufnahme, die beispielsweise durch Klemmmechanismen, Feststellschrauben oder ähnliches ergänzt sein kann, lassen sich dabei sehr geringe Toleranzen einhalten.

In einer weiteren vorteilhaften Ausgestaltung kann der Sensorhalter ein Material aufweisen, welches zumindest hinsichtlich des Wärmeausdehnungskoeffizienten mit dem Material des Sensorgehäuses im Wesentlichen identisch ist. "Im Wesentlichen identisch" bedeutet in diesem Zusammenhang, dass die Auswirkungen von unterschiedliche Materialeigenschaften im Hinblick auf die Toleranzen vernachlässigbar sind. Dadurch lassen sich negative Auswirkungen von Temperaturänderungen vermeiden. Insbesondere kann bei Temperaturänderungen ein "gemeinsames" Verformen der Bauteile erzielt werden, sodass die temperaturbedingte Toleranzabweichung minimal ist. Das Ausmaß solcher Toleranzabweichungen kann auch anhand der Temperatur relativ einfach rechnerisch ermittelt und gegebenenfalls automatisch ausgeglichen werden. Zu Beispielen von Materialien zählen Keramikmaterialien, Metalllegierungen, Kunststoffe, und Kombinationen dieser Materialien, die jeweils gemäß den Eigenschaften des Sensorgehäuses ausgewählt sind.

In vorteilhafter Weise kann der Sensorhalter und/oder das Sensorgehäuse mit einem Keramikmaterial, insbesondere einem unter Verwendung eines 3D-Druckverfahrens hergestellten Keramikmaterial hergestellt sein. Bei der Herstellung kann die zuvor ermittelte Transformation verwendet werden, um die erforderliche ausgleichende Form der Aufnahmestruktur zu errechnen. Dies kann auf Basis von Algorithmen geschehen, die auch eine Serienproduktion von Sensorhaltern ermöglicht, die speziell für eine bestimmten, zuvor vermessenen elektrooptischen Sensor maßgefertigt sind. Mit dem Keramikmaterial lassen sich auch sehr geringe und handhabbare temperaturbedingte Toleranzabweichungen realisieren.

In einer weiteren vorteilhaften Ausgestaltung kann der Sensorhalter mehrere Aufnahmestrukturen mit jeweils einem daran angeordneten elektrooptischen Sensor aufweisen. Dies erlaubt die Herstellung von Großformatkameras mit mehreren optimal ausgerichteten elektrooptischen Sensoren, die gemäß den Lehren dieser Offenbarung ausgebildet ist.

In einem weiteren Aspekt betrifft die gegenständliche Offenbarung eine Kamera mit zumindest einer Optikeinheit, zumindest einem Kameragehäuse, zumindest einer Steuerelektronik und zumindest einer Sensoranordnung.

Die gegenständliche Erfindung wird nachfolgend unter Bezugnahme auf die Figuren 1 bis 4 näher erläutert, die beispielhaft, schematisch und nicht einschränkend vorteilhafte Ausgestaltungen der Erfindung zeigen. Dabei zeigt
Fig.1 eine schematische schaubildliche Darstellung einer Messhalterung mit einem daran angeordneten elektrooptischen Sensor im Bildbereich einer optischen Messeinheit,
Fig. 2 eine Messhalterung mit einem daran angeordneten elektrooptischen Sensor in einer schematischen Querschnittsdarstellung,
Fig. 3 eine schematische Querschnittdarstellung eines in eine Aufnahmestruktur eines Sensorhalters eingesetzten elektrooptischen Sensor,
Fig. 4 eine schematische Querschnittdarstellung einer Kamera.

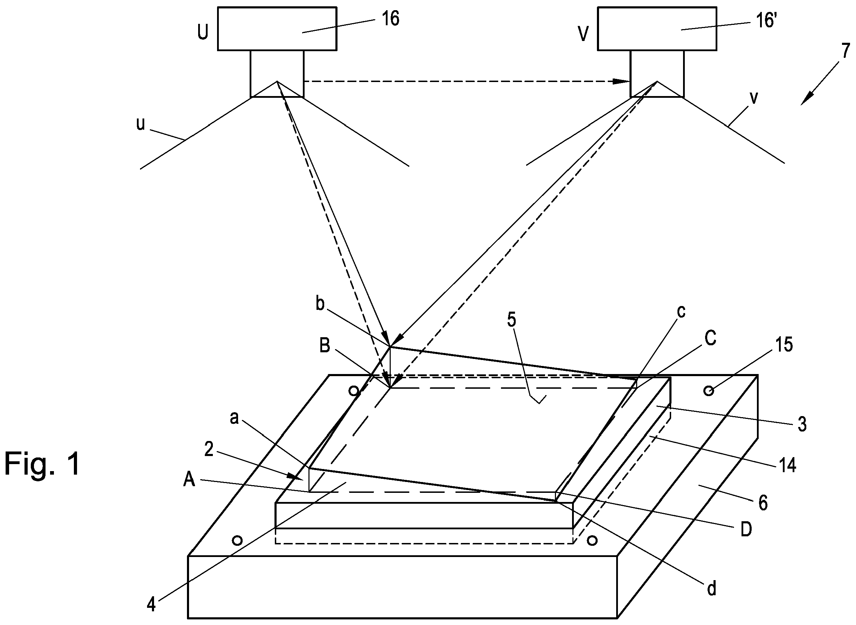

Fig. 1 zeigt eine Messhalterung 6, die eine Messausnehmung 14 aufweist, in die ein elektrooptischer Sensor 2 passend eingesetzt ist. Der elektrooptische Sensor 2 weist ein Sensorgehäuse 3 auf, an dem eine optisch aktive Sensorschicht 4 angeordnet ist. Die optisch aktive Sensorschicht 4 weist eine lichtempfindliche Ebene 5 auf, wobei dies je nach Bauart entweder die äußere Oberfläche der aktiven Sensorschicht 4 sein kann, oder eine Ebene, die ein wenig versetzt zu dieser äußeren Oberfläche liegt (dies kann beispielsweise bei der Verwendung von Mikrolinsen der Fall sein).

Als "lichtempfindliche Ebene 5" wird im Zusammenhang mit der gegenständlichen Offenbarung diejenige Ebene der aktiven Sensorschicht 4 bezeichnet, auf die die Bildebene eines Kameraobjektives ausgerichtet werden muss, um eine optische Scharfabbildung der mit der Kameraobjektive aufgenommenen Bilder zu gewährleisten.

Aufgrund zu großer Toleranzen (die auf eine herkömmliche Verwendung der elektrooptischen Sensoren 2 beispielsweise in massenmarktauglichen Digitalkameras ausgelegt sind und für diese ausreichen) kann sowohl das Sensorgehäuse 3, als auch der elektrooptische Sensor 2 in Bezug auf die Messhalterung erhebliche Abweichungen von deren Sollform aufweisen, wobei die Toleranzabweichungen in den Darstellungen der Figuren aus Gründen der Erkennbarkeit stark übertrieben dargestellt sind. Üblicherweise kann bereits eine Toleranzabweichung im Bereich von weniger als 10 µm für besonders sensible fototechnische Anwendungen eine relevante Verschlechterung der erforderlichen Bildqualität bewirken. Die allgemein von Herstellern von elektrooptischen Sensoren 2 garantierten Toleranzen liegen erheblich darüber.

Allgemein hat jeder elektrooptische Sensor 2 eine Ist-Form, die sich (innerhalb der Toleranzen) von ihrer Sollform (d.h. der Form bzw. Maße gemäß den vom Hersteller bereitgestellten Angaben) unterscheidet. Im Bezug auf einzelne Elemente des elektrooptischen Sensors, wie etwa die lichtempfindliche Ebene 5, ergibt sich daraus eine tatsächliche Position, die hierein als Ist-Lage bezeichnet wird, und eine theoretische Position, die sich ohne Toleranzabweichungen einstellen müsste, und die hierein als Soll-Lage bezeichnet wird.

Der Unterschied zwischen der Ist-Lage und der Soll-Lage kann beispielsweise anhand von "Verschiebungen" von Messpunkten a, b, c, d aus der für sie definierten Solllage A, B, C, D beschrieben werden. Wenn die lichtempfindliche Ebene 5 im Wesentlichen eben ist, kann die gesamte Verschiebung aller in der lichtempfindlichen Ebene 5 liegenden Messpunkte a, b, c, d aus der jeweiligen Solllage A, B, C, D durch eine Lagetransformation dargestellt werden, wobei die Lagetransformation beispielsweise in Form einer entsprechenden Transformationsmatrix auf einfache Weise beschrieben und weiterverarbeitet werden kann.

In der Darstellung der Fig. 1 sind beispielsweise die vier Eckpunkte der optisch aktiven Sensorschicht 4 als Messpunkte a, b, c, d definiert. Die entsprechenden Punkte sind in der in Strichlinien dargestellten Solllage der Sensorschicht 4 mit den Bezugszeichen A, B, C und D gekennzeichnet. Im dargestellten Fall befinden sich drei Messpunkte a, b und c jeweils "oberhalb" der entsprechenden Solllagen A, B, C und ein Messpunkt d ist gegenüber der entsprechenden Solllage D nach "unten" verschoben. Gegebenenfalls können die Messpunkte zusätzlich in eine beliebige seitliche Richtung verschoben sein. Die Begriffe "oben" und "unten" beziehen sich dabei auf die Darstellung in Fig. 1 und sind nicht einschränkend auszulegen. Die Abweichung der Messpunkte a, b, c, d von deren entsprechenden Solllagen A, B, C, D kann beispielsweise aufgrund einer unregelmäßigen Verklebung der optisch aktiven Sensorschicht 4 mit dem Sensorgehäuse 3 stammen, oder es kann auch das Sensorgehäuse 3 Toleranzabweichungen aufweisen, die zu einer Abweichung der Messpunkte a, b, c, d von ihrer Solllage beigetragen haben.

Die Lagetransformation des elektrooptischen Sensors kann mithilfe einer optischen Messeinheit 7 ermittelt werden.

Im in Fig. 1 dargestellten Fall wird eine Messeinheit 7 mit zumindest einer Messkamera 16, 16' verwendet, wobei jede Messkamera 16, 16' von einer oder mehreren Raumpositionen U, V aus eine oder mehrere Aufnahmen u, v von der Einheit aus Messhalterung 6 und elektrooptischen Sensor 2 macht. In Fig. 1 ist die Messkamera an der mit "U" bezeichneten Raumposition mit dem Bezugszeichen 16 versehen, und die Messkamera an der mit "V" bezeichneten Raumposition ist mit dem Bezugszeichen 16' gekennzeichnet, wobei es sich auch um eine einzige Messkamera 16 handeln kann, die zwischen den einzelnen Messaufnahmen von der einen in die andere Raumposition bewegt wird.

Die jeweilige Raumposition U, V der Messkamera 16, 16' bezogen auf die Messhalterung 6 kann entweder anhand der Ausbildung der Messeinheit 7 bekannt sein, oder sie kann für jede Aufnahme u, v anhand einer Bildauswertung ermittelt werden. Zu diesem Zweck kann die Messhalterung 6 beispielsweise definierte Vermessungsstrukturen 15 aufweisen. Anhand einer Auswertung der Messaufnahmen u, v kann die Lagetransformation zwischen der Solllage und der Ist-Lage (bzw. umgekehrt) ermittelt und in einem beliebigen Koordinatensystem definiert werden.

Gegebenenfalls können weitere sichtbare Strukturen des elektrooptischen Sensors 2 geometrisch erfasst werden. Die Herstellerspezifikation der Sensoroberfläche ist beispielsweise durch die Anzahl und Größe der einzelnen Bildelemente mit hoher geometrischer Genauigkeit angegeben und kann daher als Basis für ein kartesisches Koordinatensystem genutzt werden. Die optisch sichtbaren Strukturen auf der Sensoroberfläche können nun als Markierungen bzw. Messpunkte in diesem Koordinatensystem genutzt werden.

Gegebenenfalls kann auch die Position des Sensorgehäuses 3 anhand zusätzlicher Messpunkte (nicht dargestellte) oder bekannter Strukturen ermittelt werden, sodass auch die Lagetransformation zwischen dem Sensorgehäuse 3 und der Messhalterung 6 (bzw. zwischen dem Sensorgehäuse 3 und der optisch aktiven Sensorschicht 4) ermittelbar ist. Zu diesem Zweck können auch die Passpositionen genutzt werden, die vom Hersteller angegeben sind und die eine eindeutig Lagedefinition des Sensorgehäuses 3 erlauben. Gegebenenfalls können am Sensorgehäuse 3 sichtbare elektrische Kontakte als Messpunkte genutzt werden.

Bereits anhand einer einzelnen Messaufnahme ist es möglich, eine Lagetransformation hinsichtlich der Lage, Orientierung und des Maßstabes zu ermitteln. Anhand mehrerer Messaufnahmen aus unterschiedlichen Raumpositionen U, V kann durch Verschneidung mehrerer Sehstrahlen eine vollständig dreidimensionale Lagetransformation berechnet werden. Anhand mehrerer Messaufnahmen kann die Genauigkeit etwa mittels Methoden der Bild-Triangulation und durch eine anschließende Ausgleichsberechnung verfeinert werden.

Die Auswertung der Messbilder kann beispielsweise mit Softwaretools erfolgen, die die Bildinhalte analysieren, die zu messenden Strukturen und Messpunkte erkennen, deren Lage im Bildkoordinatensystem ermitteln und die entsprechende Transformation gegenüber der Solllage errechnen.

Die Messausnehmung 14 der Messhalterung 6 kann als eine auf die Form des Sensorgehäuses 3 abgestimmte, passförmige Ausnehmung ausgebildet sein, wobei gegebenenfalls Klemm- oder Fixierelemente die exakte Positionierung des Sensorgehäuses 3 in der Messausnehmung 14 (beispielsweise hinsichtlich einer Ecke der Messausnehmung 14) sicherstellen können. Vorzugsweise ist die Messausnehmung 14 im Wesentlichen identisch zu einer Aufnahmestruktur 8 eines Sensorhalters 9 ausgebildet, in die der elektrooptische Sensor 2 eingesetzt werden soll, und die weiter unten beschrieben ist.

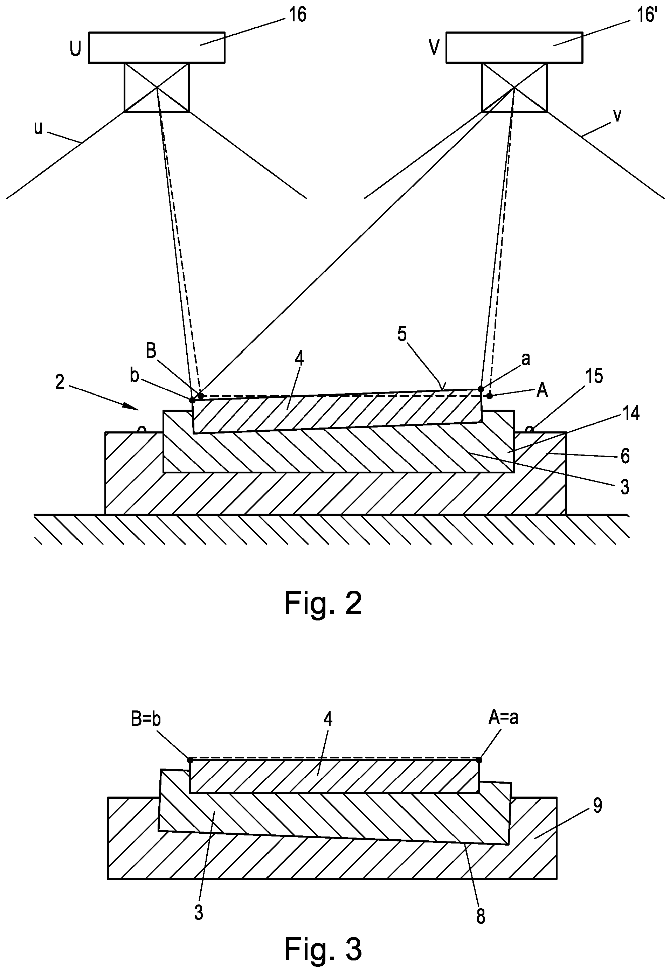

In Fig. 2 ist eine Struktur in einer nochmals vereinfachten Schnittdarstellung gezeigt, die zu der obenstehend unter Bezugnahme auf Fig. 1 beschriebenen Struktur im Wesentlichen äquivalent ist, wobei die Abweichung der Sichtstrahlen von der Messkamera 16, 16' zu den Messpunkten a, b (in durchgängigen Linien) und zu deren Solllagen A, B (in Strichlinien) dargestellt sind. Der (aus den Messaufnahmen ermittelbare) Verlauf der Sichtstrahlen erlaubt durch Triangulation eine Positionsermittlung der Messpunkte, anhand derer eine Lagetransformation ermittelt werden kann.

Die zuvor beschriebene Messeinheit und das damit ausgeführte Verfahren zur Ermittlung der Lagetransformation stellt lediglich ein Beispiel dar. Es liegt im Können des Durchschnittsfachmanns, der Kenntnis der hierin offenbarten Lehren hat, die Ermittlung der Lagetransformation auch mithilfe unterschiedlicher Messeinheiten durchzuführen.

Mithilfe der ermittelten Lagetransformation ist es möglich, den Sensorhalter 9, in den der elektrooptische Sensor 2 eingebaut werden soll, so auszubilden, dass dessen Form (bzw. die Form der Aufnahmestruktur 8 des Sensorhalters 9) die durch die Lagetransformation beschriebene Formabweichung zwischen Ist-Form und Sollform des elektrooptischen Sensors 2 ausgleicht. Der elektrooptische Sensor 2, der in diese maßgefertigte Sensorhalterung eingesetzt wird, weist nunmehr eine lichtempfindliche Ebene 5 auf, deren Ist-Lage eine deutlich geringere Abweichung gegenüber der Solllage aufweist, als dies noch im Bezug auf die Messhalterung 6 der Fall war, und dessen Anordnung daher auch deutlich geringere Toleranzen ermöglicht. Darüber hinaus ist es nicht mehr erforderlich, die Sensorhalterung 9 nach dem Befestigen des elektrooptischen Sensors 2 mittels Justierschrauben oder ähnlichem aufwändig zu justieren. Die Sensorhalterung 9 kann daher besonders einfach ausgeführt werden, beispielsweise als Passform, die gegebenenfalls Spann-, Klemm- und/oder Fixiermittel zur Befestigung des elektrooptischen Sensors 2 aufweisen kann.

Da komplexe Justierungssysteme somit nicht erforderlich sind, kann der Sensorhalter 9 beispielsweise in einem 3D-Druckverfahren hergestellt werden, beispielsweise als Keramik-3D-Druck, es können jedoch auch andere Materialien verwendet werden. Gegebenenfalls kann der mittels 3D-Druckverfahren hergestellte Sensorhalter 9 zur Verbesserung der Toleranzen nachbearbeitet sein, beispielsweise mittels eines spanabhebenden Verfahrens. In anderen Ausführungsformen kann der Sensorhalter 9 auch mittels konventioneller spanabhebender Verfahren aus einem Rohling gearbeitet werden, wobei sichergestellt sein muss, dass mit dem gewählten Verfahren die erforderlichen Toleranzen erzielbar sind.

Somit kann für jeden Sensor ein individueller Sensorhalter 9 gefertigt werden. Der einzelne elektrooptische Sensor kann nun in diesem maßgefertigten Sensorhalter 9 stabil befestigt werden und so in der zu fertigenden Kamera ohne zusätzliche Justage-Arbeiten verbaut werden. Nach der Befestigung des elektrooptischen Sensors 2 in dem individuellen, maßgefertigten Sensorhalter 9 kann eine Kontrollvermessung durchgeführt werden, um die erfolgreiche Montage und damit die geometrisch korrekte Lagerung der optisch aktiven Sensorschicht 4 zu verifizieren.

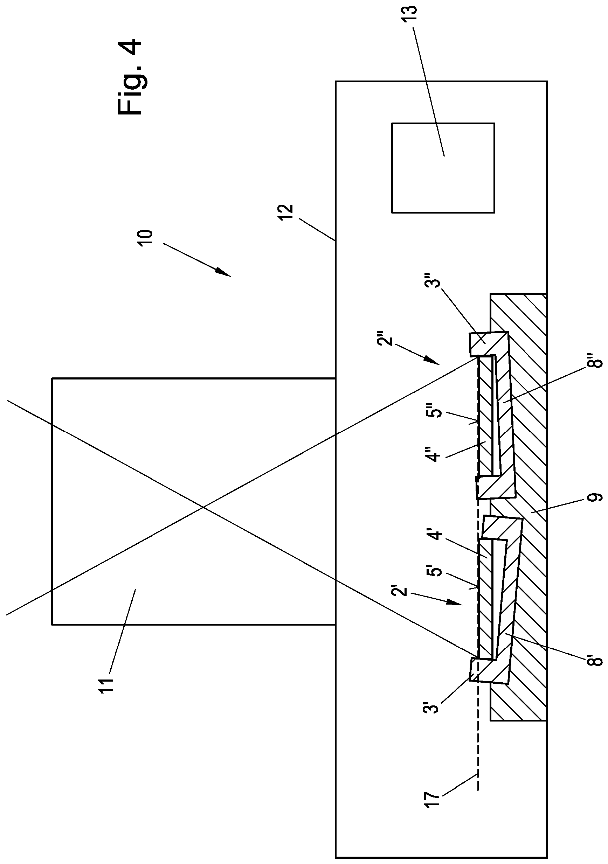

Fig. 4 zeigt eine schematische Darstellung einer Kamera 10 mit einem Gehäuse 12, einer Optikeinheit 11 und einer Steuereinheit 13. Im Bereich der Bildebene 17 der Optikeinheit 11 ist ein Sensorhalter 9 angeordnet, der zwei Aufnahmestrukturen 8' und 8" für jeweils einen elektrooptischen Sensor 2' und 2" aufweist. Die beiden Aufnahmestrukturen 8', 8" sind für die beiden daran angeordneten Sensorgehäuse 3', 3" jeweils passgenau so angefertigt, dass die lichtempfindlichen Ebenen 5', 5" der optisch aktiven Sensorschichten 4', 4" beide sehr exakt mit der Bildebene 17 in Übereinstimmung gebracht sind. Weiters ist die Position der optisch aktiven Sensorschichten 4', 4", sowie der Abstand zwischen deren Rändern mit geringer Toleranz exakt eingestellt.

Auf analoge Weise lassen sich Kameras mit einer größeren Anzahl an elektrooptischen Sensoren mit hoher Bildtreue herstellen, wie sie etwa für Anwendungen im Bereich der Photogrammetrie benötigt werden. Gegebenenfalls können einzelne elektrooptische Sensoren einer solchen mosaikartigen Anordnung auch gegenüber einer Bildebene in definierter Weise leicht geneigt und/oder erhöht bzw. vertieft angeordnet sein, um beispielsweise eine Bildfeldwölbung eines Objektivs im Bildrandbereich auszugleichen. Mithilfe der hierin beschriebenen Verfahren und Vorrichtungen lassen sich solche definierten Neigungen und Verschiebungen auf einfache und höchst exakte Weise herstellen.

Die in Fig. 1 bis 4 gezeigten schematischen Darstellungen sind jeweils auf die wesentlichsten Elemente reduziert und stark vereinfacht. Der Fachmann ist bei Kenntnis der hierin offenbarten Lehren jedoch in der Lage, diese auf praktische Fälle anzuwenden, wobei die Form und Ausgestaltung der Elemente hinsichtlich des elektrooptischen Sensors 2, des Sensorhalters 9 und/oder der Messhalterung 6 gegebenenfalls deutlich komplexer sein können. Beispielsweise ist üblicherweise der Bereich des Sensorgehäuses, in der der elektrooptische Sensor eingebracht ist, durch ein Deckglas versiegelt und geschützt. Das Deckglas ist nach Stärke und Brechungsindex bekannt und kann entsprechend berücksichtigt werden.

### Bezugszeichen:

Sensoranordnung 1
elektrooptischer Sensor 2
Sensorgehäuse 3
optisch aktive Sensorschicht 4
lichtempfindliche Ebene 5
Messhalterung 6
Messeinheit 7
Aufnahmestruktur 8
Sensorhalterung 9
Kamera 10
Optikeinheit 11
Kameragehäuse 12
Steuerelektronik 13
Messausnehmung 14
Vermessungsstrukturen 15
Messkamera 16
Bildebene 17
Raumposition U, V
Messaufnahme u, v
Messpunkt a, b, c, d
Solllage A, B, C, D

## Patentansprüche

1. Verfahren zur Herstellung einer Sensoranordnung (1), wobei das Verfahren die folgenden Schritte aufweist:
- Bereitstellen eines elektrooptischen Sensors (2) mit einem Sensorgehäuse (3) und einer daran angeordneten optisch aktiven Sensorschicht (4), welche eine lichtempfindliche Ebene (5) ausbildet,
- lagedefiniertes Anordnen des elektrooptischen Sensors (2) in einer Messausnehmung (14) einer Messhalterung (6),
- Ermitteln, mit einer Messeinheit (7), einer auf die Messhalterung (6) bezogenen Lagetransformation der Ist-Lage der lichtempfindlichen Ebene (5) gegenüber einer in Bezug auf die Messhalterung (6) definierten Solllage der lichtempfindlichen Ebene (5),
- Herstellen einer Sensorhalterung (9) mit einer unverstellbaren Aufnahmestruktur (8), welche die durch die Lagetransformation beschriebene Formabweichung des elektrooptischen Sensors (2) von einer Sollform ausgleicht,
- Befestigen des elektrooptischen Sensors (2) in der Aufnahmestruktur (8) der Sensorhalterung (9).

2. Verfahren nach Anspruch 1, **dadurch gekennzeichnet, dass** der Schritt des Ermittelns der Lagetransformation die folgenden Schritte aufweist:
- Messen, mit der Messeinheit (7), einer Abweichung zumindest eines Messpunkts (a, b, c, d) der lichtempfindlichen Ebene (5) und/oder des Sensorgehäuses (3) von einer in Bezug auf die Messhalterung (6) definierten Solllage (A, B, C, D) dieses Messpunkts (a, b, c, d),
- Ermitteln der Ist-Lage der lichtempfindlichen Ebene (5) aus zumindest einer gemessenen Abweichung,
- Ermitteln der Lagetransformation zwischen der gemessenen Position der lichtempfindlichen Ebene (5) und der Soll-Lage dieser lichtempfindlichen Ebene (5).

3. Verfahren nach Anspruch 1 oder 2, **dadurch gekennzeichnet, dass** der Schritt des Ermittelns der Lagetransformation die folgenden Schritte aufweist:
- Anordnen zumindest einer Messkamera (16) der Messeinheit (7) in zumindest einer auf die Messhalterung (6) bezogenen Raumposition (U, V),
- Erstellen zumindest einer Messaufnahme (u, v) mit der zumindest einen Messkamera (16), wobei die Messaufnahme zumindest einen Teil der lichtempfindlichen Ebene (5) und/oder des Sensorgehäuses (3) und gegebenenfalls der Messhalterung (6) umfasst,
- Ermitteln von Koordinaten des zumindest einen Messpunkts (a, b, c, d) und gegebenenfalls von Koordinaten der Soll-Lage dieses Messpunkts (A, B, C, D) aus der zumindest einen Messaufnahme (u, v),
- Ermitteln der Lagetransformation zwischen der gemessenen Position der lichtempfindlichen Ebene (5) und der Soll-Lage dieser lichtempfindlichen Ebene (5) aus den Koordinaten.

4. Verfahren nach Anspruch 3, **dadurch gekennzeichnet, dass** zumindest eine auf die Messhalterung (6) bezogene Raumposition (U, V) auf Basis der entsprechenden Messaufnahme (u, v) ermittelt wird.

5. Verfahren nach einem der Ansprüche 1 bis 4, **dadurch gekennzeichnet, dass** die Sensorhalterung (9) mit der Aufnahmestruktur (8) unter Verwendung eines 3D-Druckverfahrens hergestellt wird.

6. Verfahren nach einem der Ansprüche 1 bis 5, **dadurch gekennzeichnet, dass** die Sensorhalterung (9) mit der Aufnahmestruktur (8) unter Verwendung eines spanabhebenden Verfahrens hergestellt wird.

7. Verfahren nach einem der Ansprüche 1 bis 6, **dadurch gekennzeichnet, dass** mehrere elektrooptische Sensoren (2) in mehreren Aufnahmestrukturen (8) einer einzigen Sensorhalterung (9) befestigt werden.

8. Kamera (10) mit zumindest einer Optikeinheit (11), zumindest einem Kameragehäuse (12), zumindest einer Steuerelektronik (13) und zumindest einer Sensoranordnung (1) hergestellt mit dem Verfahren gemäß einem der Ansprüche 1 bis 7.

## Claims

1. Method for producing a sensor arrangement (1), wherein the method comprises the following steps:
- providing an electro-optical sensor (2) having a sensor housing (3) and an optically active sensor layer (4) arranged thereon, which forms a light-sensitive plane (5),
- arranging the electro-optical sensor (2) in a positionally defined manner in a measuring recess (14) of a measuring holder (6),
- determining, by means of a measuring unit (7), a position transformation of the actual position of the light-sensitive plane (5) relative to the measuring holder (6) with respect to a desired position of the light-sensitive plane (5) defined in relation to the measuring holder (6),
- producing a sensor holder (9) having a non-adjustable receiving structure (8) which compensates for the deviation in shape of the electro-optical sensor (2) from a desired shape, which deviation is described by the position transformation,
- securing the electro-optical sensor (2) in the receiving structure (8) of the sensor holder (9).

2. Method according to claim 1, **characterized in that** the step of determining the position transformation comprises the following steps:
- measuring, by means of the measuring unit (7), a deviation of at least one measurement point (a, b, c, d) of the light-sensitive plane (5) and/or of the sensor housing (3) from a desired position (A, B, C, D) of this measurement point (a, b, c, d) that is defined in relation to the measuring holder (6),
- determining the actual position of the light-sensitive plane (5) from at least one measured deviation,
- determining the position transformation between the measured position of the light-sensitive plane (5) and the desired position of this light-sensitive plane (5).

3. Method according to either claim 1 or claim 2, **characterized in that** the step of determining the position transformation comprises the following steps:
- arranging at least one measuring camera (16) of the measuring unit (7) in at least one spatial position (U, V) relative to the measuring holder (6),
- creating at least one measurement recording (u, v) using the at least one measuring camera (16), the measurement recording comprising at least part of the light-sensitive plane (5) and/or of the sensor housing (3) and optionally of the measuring holder (6),
- determining coordinates of the at least one measurement point (a, b, c, d) and, if necessary, coordinates of the desired position of this measurement point (A, B, C, D) from the at least one measurement recording (u, v),
- determining the position transformation between the measured position of the light-sensitive plane (5) and the desired position of this light-sensitive plane (5) from the coordinates.

4. Method according to claim 3, **characterized in that** at least one spatial position (U, V) relative to the measuring holder (6) is determined on the basis of the corresponding measurement recording (u, v).

5. Method according to any of claims 1 to 4, **characterized in that** the sensor holder (9) having the receiving structure (8) is produced using a 3D printing process.

6. Method according to any of claims 1 to 5, **characterized in that** the sensor holder (9) having the receiving structure (8) is produced using a machining process.

7. Method according to any of claims 1 to 6, **characterized in that** a plurality of electro-optical sensors (2) are secured in a plurality of receiving structures (8) of a single sensor holder (9).

8. Camera (10) comprising at least one optical unit (11), at least one camera housing (12), at least one control electronics (13) and at least one sensor arrangement (1) produced by the method according to any of claims 1 to 7.

## Revendications

1. Procédé permettant la production d'un ensemble capteur (1), dans lequel le procédé présente les étapes suivantes :
- la fourniture d'un capteur électro-optique (2) comportant un boîtier de capteur (3) et une couche de capteur (4) optiquement active disposée sur celui-ci, qui forme un plan photosensible (5),
- l'agencement défini en position du capteur électro-optique (2) dans un évidement de mesure (14) d'un support de mesure (6),
- la détermination, avec une unité de mesure (7), d'une transformation de position, rapportée au support de mesure (6), de la position réelle du plan photosensible (5) par rapport à une position de consigne, définie par rapport au support de mesure (6), du plan photosensible (5),
- la production d'un support de capteur (9) comportant une structure de réception (8) non réglable, qui compense l'écart de forme, décrit par la transformation de position, du capteur électro-optique (2) par rapport à une forme de consigne,
- la fixation du capteur électro-optique (2) dans la structure de réception (8) du support de capteur (9).

2. Procédé selon la revendication 1, **caractérisé en ce que** l'étape de détermination de la transformation de position présente les étapes suivantes :
- la mesure, avec l'unité de mesure (7), d'un écart d'au moins un point de mesure (a, b, c, d) du plan photosensible (5) et/ou du boîtier de capteur (3) par rapport à une position de consigne (A, B, C, D) de ce point de mesure (a, b, c, d) définie par rapport au support de mesure (6),
- la détermination de la position réelle du plan photosensible (5) à partir d'au moins un écart mesuré,
- la détermination de la transformation de position entre la position mesurée du plan photosensible (5) et la position de consigne de ce plan photosensible (5).

3. Procédé selon la revendication 1 ou 2, **caractérisé en ce que** l'étape de détermination de la transformation de position présente les étapes suivantes :
- l'agencement d'au moins une caméra de mesure (16) de l'unité de mesure (7) dans au moins une position spatiale (U, V) par rapport au support de mesure (6),
- la réalisation d'au moins une prise de mesure (u, v) avec l'au moins une caméra de mesure (16), dans lequel la prise de mesure comprend au moins une partie du plan photosensible (5) et/ou du boîtier de capteur (3) et le cas échéant le support de mesure (6),
- la détermination de coordonnées de l'au moins un point de mesure (a, b, c, d) et, le cas échéant, de coordonnées de la position de consigne de ce point de mesure (A, B, C, D) à partir de l'au moins une prise de mesure (u, v),
- la détermination de la transformation de position entre la position mesurée du plan photosensible (5) et la position de consigne de ce plan photosensible (5) à partir des coordonnées.

4. Procédé selon la revendication 3, **caractérisé en ce qu'**au moins une position spatiale (U, V) par rapport au support de mesure (6) est déterminée sur la base de la prise de mesure (u, v) correspondante.

5. Procédé selon l'une des revendications 1 à 4, **caractérisé en ce que** le support de capteur (9) comportant la structure de réception (8) est produit par le biais d'un procédé d'impression 3D.

6. Procédé selon l'une des revendications 1 à 5, **caractérisé en ce que** le support de capteur (9) comportant la structure de réception (8) est produit par le biais d'un procédé par enlèvement de copeaux.

7. Procédé selon l'une des revendications 1 à 6, **caractérisé en ce que** plusieurs capteurs électro-optiques (2) sont fixés dans plusieurs structures de réception (8) d'un seul support de capteur (9).

8. Caméra (10) comportant au moins une unité optique (11), au moins un boîtier de caméra (12), au moins une électronique de commande (13) et au moins un ensemble capteur (1) produit avec le procédé selon l'une des revendications 1 à 7.
